# EUROPÄISCHE PATENTANMELDUNG

(11) **EP 4 296 637 A1**
(43) Veröffentlichungstag der Anmeldung: **27.12.2023**
(21) Anmeldenummer: 23179319.1
(22) Anmeldetag: 14.06.2023
(51) Int. Cl.: G01J 3/42, G01N 21/3581, G01R 23/167

(54) **VERFAHREN UND VORRICHTUNG ZUR BANDBREITENERWEITE-RUNG EINES PHOTONISCHEN DAUERSTRICH-SPEKTROMETERS**

(30) Priorität: 21.06.2022 DE 102022115387
(71) Anmelder: Technische Universität Darmstadt, 64289 Darmstadt (DE)
(72) Erfinder: Preu, Sascha, 64367 Mühltal (DE); Mukherjee, Amlan Kusum, 64287 Darmstadt (DE)
(74) Vertreter: LifeTech IP Spies & Behrndt Patentanwälte PartG mbB

(57) **Zusammenfassung**

Es ist ein Verfahren zur Bandbreitenerweiterung eines photonischen Dauerstrich-Spektrometers für ein Empfangssignal (20) in einem Terahertz-Frequenzbereich offenbart. Das Verfahren umfasst die Schritte: Bereitstellen (S110) eines Eingangssignals (115) im Frequenzbereich basierend auf dem Empfangssignal (20); Transformieren (S120) des Frequenzsignals (115) in ein Zeitsignal; Ermitteln (S125) eines digitalen Filters; Filtern (S130) des Zeitsignals durch den ermittelten digitalen Filter; und Spektrale Verarbeitung (S150) des Ausgabe-Frequenzsignals (125) zur Ermittlung eines Leistungsspektrums (135).

## Beschreibung

Die vorliegende Erfindung bezieht sich auf ein Verfahren und eine Vorrichtung zur Bandbreitenerweiterung eines photonischen Dauerstrich-Spektrometers und insbesondere auf eine Bandbreitenerweiterung von Terahertz- (THz-) Photomischersystemen mittels Rauschunterdrückung.

### HINTERGRUND

Der Terahertzbereich (0.1-10 THz) ist für die Spektroskopie von polaren Gasen und anderen polaren Materialien oder Medien sehr gut geeignet. Dafür werden durchstimmbare oder breitbandige THz-Systeme mit hohem Dynamikbereich (DNR) benötigt. Für diese THz-Spektroskopie können beispielsweise Dauerstrichlasersysteme eingesetzt werden, die gepulsten Lasersystemen üblicherweise in der Frequenzauflösung deutlich überlegen sind. Eine hohe Frequenzauflösung ist zur Messung schmaler spektraler Eigenschaften wichtig. Andere konventionelle Systemen nutzen zur Erzeugung von THz-Signalen beispielsweise rein elektronische Systeme, die beispielsweise Transistoren nutzen und mittels Frequenzvervielfachung den Zielfrequenzbereich erreichen.

Da Laser prinzipiell in einem Bereich von mehreren THz durchstimmbar sind, wird die Bandbreite von photonischen Systemen durch den immer kleiner werdenden Dynamikbereich mit steigender Frequenz begrenzt. Die Bandbreite wird daher von zwei Effekten begrenzt:
(i) der prinzipiellen Durchstimmbarkeit von Quelle und Empfänger und
(ii) dem Abstand des Signals zum Rauschuntergrund.

Diese Abstand wird mit steigender Frequenz immer geringer, sodass das Nutzsignal schließlich in den Rauschuntergrund verschwindet. Da photonische Systeme prinzipiell weit durchstimmbar sind, stellt der Effekt (i) keine Begrenzung dar. Die Bandbreite ergibt sich letztlich dadurch, bei welcher Frequenz das Messsignal in den Rauschuntergrund eintaucht.

In konventionellen Systemen werden zur Unterdrückung des Rauschens eine Reihe von Techniken eingesetzt. Standard ist die "Lock-in" Technik, bei der das abgestrahlte THz-Signal niederfrequent moduliert wird und dann im Lock-in Verstärker explizit nach Komponenten bei der Modulationsfrequenz gesucht wird. Die Rauschbandbreite ist invers proportional zur Messdauer pro Punkt (Integrationszeit), d.h. je stärker man das Rauschen unterdrücken möchte, je länger wird integriert. Auf diese Weise wird das Rauschen durch zeitintensives langes Mitteln reduziert. Eine Verbesserung des SNR (signal-noise-ratio; Signal-Rausch-Verhältnis) bzw. DNR (dynamic-noise-ratio, Dynamikbereich) um einen Faktor 10 kann so eine 10-mal längere Messzeit bei einem Homodynsystem erfordern. Eine lange Messzeit ist aber oft nicht praktikabel, sodass bei diesen konventionellen Systemen häufig ein Kompromiss zwischen Messzeit und SNR eingegangen wird.

Es können auch Tiefpassfilter verwendet werden, um Rauschen in spektroskopischen Daten, die schon in einem System mit hohem Dynamikbereich gemessen wurden, zu vermindern. Eine andere konventionelle Technik basiert auf den sogenannten Wavelets, die jedoch bei scharfen spektroskopischen Signaturen ("spektrale Fingerprints") nachteilig sind, da diese Technik die Form der Signaturen beeinflusst.

Es besteht daher ein Bedarf nach THz-Spektrometern mit einer deutlich vergrößerten Bandbreite, ohne dass dazu die Messzeit verlängert werden müsste.

### KURZBESCHREIBUNG DER ERFINDUNG

Zumindest ein Teil der obengenannten Probleme wird durch ein Verfahren zum nach Anspruch 1 und eine Vorrichtung nach Anspruch 8 gelöst. Die abhängigen Ansprüche beziehen sich auf vorteilhafte Weiterbildungen der Gegenstände der unabhängigen Ansprüche.

Die vorliegende Erfindung bezieht sich auf ein Verfahren zur Bandbreitenerweiterung eines photonischen Dauerstrich-Spektrometers für ein Empfangssignal im Terahertz-Frequenzbereich. Das Verfahren umfasst die Schritte:
- Bereitstellen eines (ggf. gefilterten) Eingangssignals im Frequenzbereich basierend auf dem Empfangssignal;
- Transformieren des Eingangssignals in ein Zeitsignal;
- Ermitteln eines digitalen Filters und einer zugehörigen Filterfunktion; und
- Faltung der Filterfunktion mit dem Empfangssignal zu einem Ausgabe-Frequenzsignal zur Ermittlung eines Leistungsspektrums.

Optional kann die Filterfunktion durch ein Rücktransformieren des Filters in den Frequenzbereich erfolgen.

Optional kann die Filterung auch direkt im Zeitbereich erfolgen (z.B. unter Nutzung einer Fensterfunktion) und das Ausgabe-Frequenzsignal durch Rücktransformation erhalten werden. Der Vorteil des obig beschriebenen Verfahrens ist jedoch, dass die Schritte "Transformieren", "Ermitteln" und "Rücktransformieren" für einen gegebenen Messaufbau nur einmalig durchgeführt werden müssen. Sobald eine sinnvolle Filterfunktion bekannt ist, kann diese direkt im Frequenzbereich auf weitere Empfangssignaldatensätze angewandt werden (durch Ausführen der o.g. Schritte).

Das ermittelte Leistungsspektrum wird von dem Ausgabe-Frequenzsignal ermittelt, bezieht aber letztlich auf das Empfangssignal, dessen spektrale Information zumindest teilweise im Ausgabe-Frequenzsignal enthalten ist.

Optional wird in dem Schritt des digitalen Filterns Folgendes verwendet: ein Filter mit unendlicher Impulsantwort, IIR-Filter, und/oder ein Filter mit endlicher Impulsantwort, FIR-Filter.

Optional umfasst das Filtern des Zeitsignal Folgendes: Bestimmen eines Hauptmaximums und/oder Herausfiltern von Nebenmaxima, welche z.B. durch unerwünschte Stehwellen im Messaufbau entstehen. Hierzu kann eine Fensterfunktion (Bandpass) festgelegt oder erzeugt werden. Die Fensterfunktion kann beispielsweise basierend auf das bestimmte Hauptmaximum festgelegt werden. Eine Filterbreite (Breite des zeitlichen Fensters) kann beispielsweise eine doppelte Signalbreite des Hauptmaximums sein.

Optional können auch mehrere Bandpassfilter eingesetzt werden.

Optional wird in dem Schritt des Bereitstellens des Eingangssignals zumindest eines aus dem Folgendes verwendet wird:
- ein homodyner Photomischer,
- ein heterodyner Photomischer,
- ein Photoleiter,
- ein Lock-in Verstärker mit einer Integrationszeit in einem Bereich von 1 µs bis zu 1 s oder in einem engeren Bereich von 1 ms bis 300 ms oder von höchstens 5 ms,
- rauscharmer Transimpedanzverstärker;
- ein Tiefpassfilter.

Das Eingangssignal kann daher ein gefilterte Frequenzsignal sein.

Optional beträgt die Bandbreite im Frequenzbereich zumindest 1 THz oder zumindest 5 THz, wobei insbesondere ein interessierender Bereich eingestellt werden kann (z.B. zwischen 1,7 THz und 1,8 THz). Ausführungsbeispiele bieten den Vorteil, dass die Bandbreite, in der Untersuchungen durchgeführt werden können, deutlich größer ist als bei herkömmlichen Systemen.

Optional werden die Schritte des Transformierens, des Filterns und des Rücktransformierens durch eine Multiplikation im Zeitbereich ausgeführt.

Dieses Verfahren oder zumindest Teile davon kann/können ebenfalls in Form von Anweisungen in Software oder auf einem Computerprogrammprodukt implementiert oder gespeichert sein, wobei gespeicherte Anweisungen in der Lage sind, die Schritte nach dem Verfahren auszuführen, wenn das Verfahren auf einem Prozessor läuft. Daher bezieht sich die vorliegende Erfindung ebenfalls auf ein Computerprogrammprodukt oder ein Computer-lesbares Speichermedium mit darauf gespeichertem Software-Code (Softwareanweisungen), der/das ausgebildet ist, um eines der zuvor beschriebenen Verfahren auszuführen, wenn der Software-Code durch eine Verarbeitungseinheit ausgeführt wird. Die Verarbeitungseinheit kann jede Form von Computer oder Steuereinheit sein, die zumindest einen entsprechenden Mikroprozessor und einen Speicher aufweist, der einen Software-Code ausführen kann.

Ausführungsbeispiele beziehen sich auch auf eine Vorrichtung zur Bandbreitenerweiterung eines photonischen Dauerstrich-Spektrometers für ein Terahertz-Empfangssignal. Die Vorrichtung umfasst ein Bereitstellungsmodul, ein Transformationsmodul und ein Verarbeitungsmodul. Das Bereitstellungsmodul ist ausgebildet, um ein Eingangssignal basierend auf dem THz-Empfangssignals bereitzustellen. Das Transformationsmodul ist ausgebildet, um das Eingangssignal in den Zeitbereich zu transformieren und eine geeignete Filterfunktion zu finden. Das Verarbeitungsmodul ist das ausgebildet, um die Filterfunktion auf ein Empfangssignal anzuwenden und ein Leistungsspektrum des Ausgabe-Frequenzsignals zu ermitteln.

Optional umfasst das Bereitstellungsmodul einen rauscharmen Transimpedanzverstärker und/oder einen Frequenzfilter und/oder einen Lock-in-Verstärker.

Optional ist das Verarbeitungsmodul ausgebildet, um Folgendes auszuführen:
- Filtern über Falten einer zuvor ermittelten Filterfunktion im Frequenzbereich, oder
- Transformieren in den Zeitbereich, Anwenden einer Fensterfunktion, Rücktransformieren in den Frequenzbereich.

Ausführungsbeispiele überwinden somit die eingangs genannten Probleme konventioneller Systeme dadurch, dass ein homodyn empfangenes Signal in einem dauerstrichbetriebenen THz-System mit einem Bandpassfilter im Zeitbereich (Zeitfenster) verarbeitet wird. Beispielhaft wurde in Testmessungen eine Erhöhung der Systembandbreite um bis zu 50% und eine Erhöhung des Dynamikbereichs um bis zu 20 dB gezeigt. Die entsprechende Datenverarbeitung kann weniger als eine Zehntelsekunde dauern.

Weitere Vorteile von Ausführungsbeispielen können wie folgt zusammengefasst werden:
Ausführungsbeispiele erlauben ein Unterdrücken von Rauschen durch die genannte Filterung der gemessenen Daten, ohne die Messzeit zu verlängern. Dies ermöglicht einen deutlich höheren Dynamikbereich und eine deutlich größere Bandbreite/Frequenzabdeckung des Messsystems. Änderungen an der Hardware sind dazu nicht erforderlich. Tests haben ergeben, dass der durch die Nachbearbeitung (postprocessing) bedingte Verlust an spektraler Auflösung sehr gering ist (häufig nicht messbar) und außerdem vorhersagbar.

In Testmessungen waren die verarbeiteten Daten mit Messungen mit einer 100-fach größeren Integrationszeit vergleichbar. Es ergab sich:
- eine massive Zeitersparnis für den Benutzer des Systems
- eine deutliche Verbesserung der Kenndaten des Systems (Dynamikbereich, nutzbare Bandbreite/Durchstimmbereich),
- die Datenverarbeitung kann in vorhandenen Systemen ohne Mehraufwand eingesetzt werden,
- Ausführungsbeispiele sind auch für elektronische Homodyn- oder Heterodynsysteme geeignet.

### KURZBESCHREIBUNG DER FIGUREN

Die Ausführungsbeispiele der vorliegenden Erfindung werden besser verstanden anhand der folgenden detaillierten Beschreibung und den beiliegenden Zeichnungen der unterschiedlichen Ausführungsbeispiele, die jedoch nicht so verstanden werden sollten, dass sie die Offenbarung auf die spezifischen Ausführungsformen einschränken, sondern lediglich der Erklärung und dem Verständnis dienen.
- Fig. 1: zeigt ein schematisches Flussdiagramm eines Ausführungsbeispiele der vorliegenden Erfindung.
- Fig. 2: zeigt einen THz-Spektrometer gemäß Ausführungsbeispielen.
- Fig. 3: veranschaulicht die Arbeitsweise des Bereitstellungsmoduls und des Transformationsmoduls.
- Fig. 4: zeigt ein weiteres Flussdiagramm für eine weitere Verfahrensweise gemäß einem weiteren Ausführungsbeispiel.
- Fig. 5: veranschaulicht den Zusammenhang der Verringerung der Frequenzauflösung in Abhängigkeit von der relativen Filterbreite.
- Fig. 6: zeigen Vergleichsexperimente von Ausführungsbeispielen im Vergleich zur konventionellen Verlängerung der Integrationszeiten in Lock-in Verstärkern.

### DETAILLIERTE BESCHREIBUNG

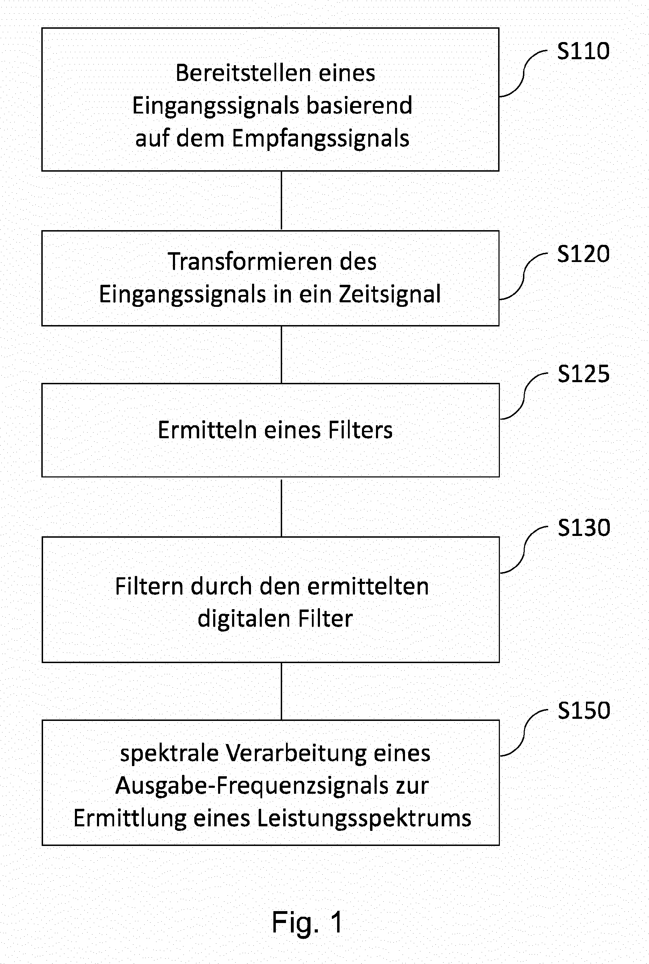

Fig. 1 zeigt ein schematisches Flussdiagramm eines Ausführungsbeispiels für ein Verfahren zur Bandbreitenerweiterung eines photonischen Dauerstrich-Spektrometers für ein Empfangssignal in einem Terahertz-Frequenzbereich. Das Verfahren umfasst die Schritte:
- Bereitstellen Sno eines Eingangssignals basierend auf dem Empfangssignals;
- Transformieren S120 des Eingangssignals in ein Zeitsignal;
- Ermitteln S125 eines digitalen Filters;
- Filtern S130 durch den digitalen Filter, wobei ein Ausgabe-Frequenzsignal erzeugt wird; und
- Spektrale Verarbeitung S150 des Ausgabe-Frequenzsignals zur Ermittlung eines Leistungsspektrums.

Zusätzlich oder Teil der Ermittlung des Filters kann noch ein Schritt des Rücktransformierens des Filters oder der Filterfunktion in den Zeitbereich erfolgen (z.B. falls kein Standardfilter für eine spezifische Anwendung genutzt werden soll). Nachdem der Filter im Zeitbereich bestimmt und in den Frequenzbereich transformiert wurde, kann der Schritt des Filterns dann direkt im Frequenzbereich durch ein Falten mit zugehörigen Filterkoeffizienten ausgeführt werden. Der Filter stellt im Zeitbereich eine Fensterfunktion dar, die im Frequenzbereich Filterkoeffizienten entspricht.

Dieses Verfahren kann ebenfalls Computer-implementiert sein, d.h. es kann durch Anweisungen umgesetzt sein, die auf einem Speichermedium gespeichert sind und in der Lage sind, die Schritte des Verfahrens auszuführen, wenn es auf einem Prozessor läuft. Die Anweisungen umfassen typischerweise eine oder mehrere Anweisungen, die auf unterschiedliche Art auf unterschiedlichen Medien in oder peripher zu einer Steuereinheit (mit einem Prozessor) gespeichert sein können, die, wenn sie gelesen und durch die Steuereinheit ausgeführt werden, die Steuereinheit dazu veranlassen, Funktionen, Funktionalitäten und Operationen auszuführen, die zum Ausführen eines Verfahrens gemäß der vorliegenden Erfindung notwendig sind.

Es versteht sich, dass alle im weiteren beschriebenen Funktionen des Spektrometers als weitere optionale Verfahrensschritte ausgebildet sein können. Außerdem versteht es sich, dass die Reihenfolge der Nennung nicht notwendigerweise eine Reihenfolge bei der Ausführung der Verfahrensschritte ist. Die Schritte können auch in einer anderen Reihenfolge ausgeführt werden bzw. es wird nur ein Teil der Verfahrensschritte ausgeführt.

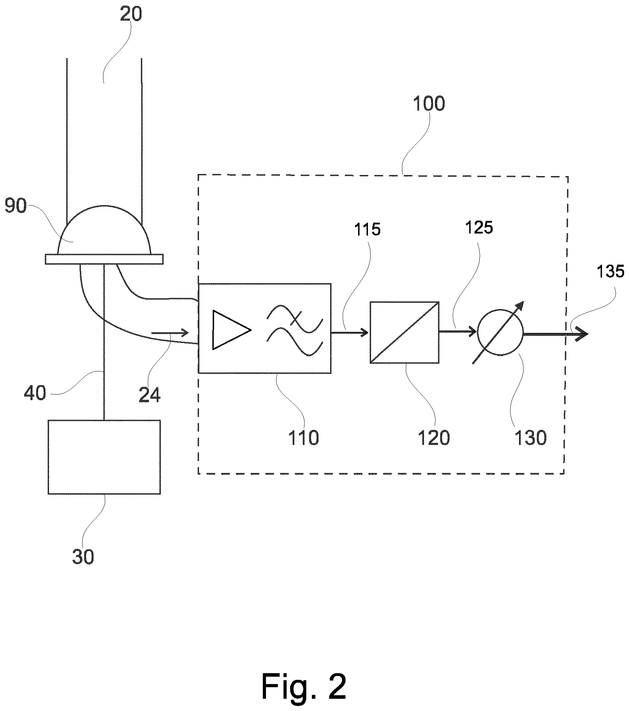

**Fig. 2** zeigt eine schematische Darstellung eines Spektrometers mit einer Vorrichtung 100 zur Bandbreitenerweiterung des Spektrometers gemäß einem Ausführungsbeispiel. Das Spektrometer ist ein photonisches Dauerstrich-Spektrometer für ein Terahertz-Empfangssignal 20. Das Empfangssignal 20 wird durch einen opto-elektronischen Mischer 90 (Photomischer), welcher gegebenenfalls mit einer entsprechenden Antenne ausgestattet ist (nicht gezeigt in Fig. 2), empfangen. Der Photomischer 90 ist ausgebildet, um ein elektrisches Überlagerungssignal 24 durch eine Überlagerung des Empfangssignals 20 und eines optischen Referenzsignals 40 zu erzeugen, wobei das Referenzsignal 40 zumindest eine bekannte Frequenz aufweist. Dazu kann der Photomischer 90 beispielsweise einen Photoleiter aufweisen.

Das Referenzsignal 40 kann von einer Quelle 30 (Referenzstrahlungsquelle) erzeugt werden, kann aber auch durch Überlagerung von mehreren optischen Signalen von verschiedenen Quellen erzeugt werden. Die Quelle 30 kann beispielsweise eine oder mehrere Laserquellen oder einen Multimodenlaser umfassen, die als Referenzsignal 40 eine Überlagerung von einem oder mehreren Lasersignalen ausgeben. Der Photomischer 90 kann beispielsweise zwei Lasersignale mischen, die sich um eine Lokaloszillator THz-Frequenz unterscheiden. Durch Überlagerung der beiden beispielhaften Laser entsteht so eine Schwebung bei der Differenzfrequenz, welche vom Photomischer 90 mit dem THz Signal 100 gemischt und in einen Gleichstrom oder Wechselstrom 24 umgesetzt wird.

Die Vorrichtung 100 zur Bandbreitenerweiterung ist ausgebildet, das zuvor beschriebene Verfahren auszuführen (siehe Fig. 1), und umfasst dazu ein Vorverarbeitungsmodul 110, Transformationsmodul 120 und ein Verarbeitungsmodul 130.

Das Bereitstellungsmodul 110 empfängt das Überlagerungssignal 24 und kann optional einen rauscharmen Transimpedanzverstärker und/oder einen Frequenzfilter und/oder einen Lock-in-Verstärker und/oder eine zeitliche Mittelung aufweisen, um ein Eingangssignal 115 basierend auf dem Empfangssignals 20 bereitzustellen. Der Frequenzfilter umfasst beispielsweise einen Tiefpassfilter, um eine Arbeitsbandbreite im Frequenzbereich zu definieren.

Das Transformationsmodul 120 ist ausgebildet, um eine geeignete Filterfunktion im Zeitbereich zu ermitteln (z.B. Fensterfunktion), gefolgt von einer anschließenden Rücktransformation der Filterfunktion in den Frequenzbereich. Als Ergebnis wird die Filterfunktion in den Frequenzbereich 125 bereitgestellt.

Das Verarbeitungsmodul 130 ist ausgebildet, um das Ausgabe-Frequenzsignal 125 des Transformationsmoduls 120 zu verarbeiten und auf ein (gefiltertes) Eingangssignal mittels Faltung im Frequenzbereich anzuwenden. Es ermittelt ferner ein Leistungsspektrum 135 und stellt dies bereit. Zur eigentlichen Filterung durch die Faltung wird das Transformationsmodul 120 nicht mehr benötigt (da der Filter dann bekannt ist). Wenn aber die Filterung direkt im Zeitbereich durch Anwendung einer Fensterfunktion ausgeführt werden soll, kann dazu das Transformationsmodul 120 eingesetzt werden.

Gemäß Ausführungsbeispielen werden Spektrallinien und deren Intensität ermittelt (z.B. Absorptionslinien von Wasser). Das Verarbeitungsmodul 130 stellt diese spektrale Information 135 zur weiteren Nutzung zur Verfügung. Dem Fachmann ist klar, dass diese Vorgehensweise äquivalent zu einer Multiplikation im Zeitbereich ist, da das Falten im Frequenzbereich mathematisch gleichwertig mit Multiplikation einer der Faltung entsprechend charakteristischen Funktion im Zeitbereich ist.

Es versteht sich, dass die Vorrichtung 100 in einer Datenverarbeitungseinheit (oder Computer) mittels Software implementiert sein kann, d.h. die Module 110, 120, 130 können sich auf software-implementierte Funktionen beziehen.

Gemäß Ausführungsbeispielen ist der hier beschriebene Detektionsprozess umgekehrt zu dem Prozess der Erzeugung und des Abstrahlens von THz-Signalen (in der Quelle). Insbesondere kann dieselbe Laser-Quelle zum Betrieb des Empfängers und des Senders verwendet werden. Das Empfangssignal 20 kann also phasen- und frequenzgelockt zum Sendesignal sein.

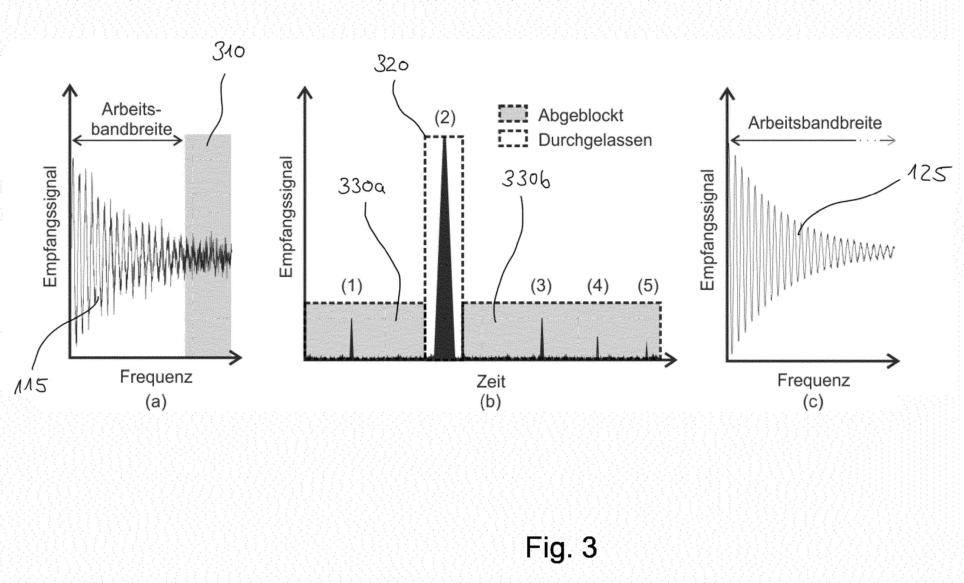

**Fig. 3** veranschaulicht die Arbeitsweise Bereitstellungsmoduls 110 und des Transformationsmoduls 120 und des Verarbeitungsmoduls 130.

**Fig. 3(a)** zeigt ein empfangenes Signal im Frequenzbereich. Bei hohen Frequenzen (siehe Bereich 310) nimmt das Signal 24 stark ab, die nutzbare Arbeitsbandbreite kann somit kleiner sein als der Arbeitsbereich. Das Signal in dem Arbeitsbereich ist das gefilterte Frequenzsignal 115 (siehe Schritt S110 in Fig. 1). Gemäß Ausführungsbeispielen kann der Arbeitsbereich sehr breit eingestellt werden, da Ausführungsbeispiele eine effektive Rauschunterdrückung z.B. mittels Lock-in Technik bieten.

**Fig. 3 (b)** zeigt das transformierte Signal (genauer gesagt das Fourier-transformiertes Signal) im Zeitbereich (nach dem Schritt S120 in Fig. 1). Das Signal zeigt ein Hauptmaximum (2) und Nebenmaxima (1), (3), (4) und (5), die beispielsweise durch unerwünschte Reflexionen im Aufbau verursacht werden können. Das Hauptmaximum (2) ist das Signal von Interesse. Daher wird gemäß Ausführungsbeispielen ein Filter im Zeitbereich umgesetzt (siehe Schritt S130 in Fig. 1), der ein Zeitfenster 320 definiert und die Signalanteile 330a (vor dem Hauptmaximum) und 330b (nach dem Hauptmaximum) herausfiltert. Das Zeitfenster 320 kann eine Breite aufweisen, die beispielsweise der doppelten Signalbreite des Hauptmaximums (2) entspricht (z.B. gemessen auf einen vorbestimmten Abstand von Signalhöhe). Prinzipiell sind auch mehrere Zeitfenster möglich.

**Fig. 3 (c)** zeigt das gefilterte Signal 125 im Frequenzbereich. Das Rauschen ist stark unterdrückt, so dass auch bei hohen Frequenzen das Signal nicht mehr im Rauschen liegt. Im Gegensatz zu konventionellen Systemen wird somit auch der hochfrequente Anteil 310 nutzbar, der bei konventionellen Systemen wegen des starken Rauschens nicht nutzbar ist. Der höhere Arbeitsbereich wird durch das Filtern im Zeitbereich ermöglicht, bei dem die Zeitbereiche 330a, 330b zusammen mit dem dort vorhandenen Rauschen herausfiltert werden. Die Gesamtrauschmenge wird dadurch deutlich verringert. Als Folge kann der Arbeitsbereich (siehe Fig. 3(a)) deutlich verbreitert werden.

Außerdem ermöglichen Ausführungsbeispiele neben der erweiterten Arbeitsbandbreite auch einen vergrößerten Dynamikbereich des beispielhaften dauerstrichbetriebenen, homodynen THz-Systems (siehe Fig. 2). Im Gegensatz zu konventionellen System wird dies mit einer vernachlässigbaren Verlängerung der Messzeit erreicht. Wenn z.B. bei Ausführungsbeispielen der Filter den Zeitbereich um einen Faktor 100 einschränkt, dann verringert sich dadurch das Rauschen des gemessenen THz-Feldes um einen Faktor 10, das Rauschen der Leistung somit um einen Faktor 100, also 20 dB.

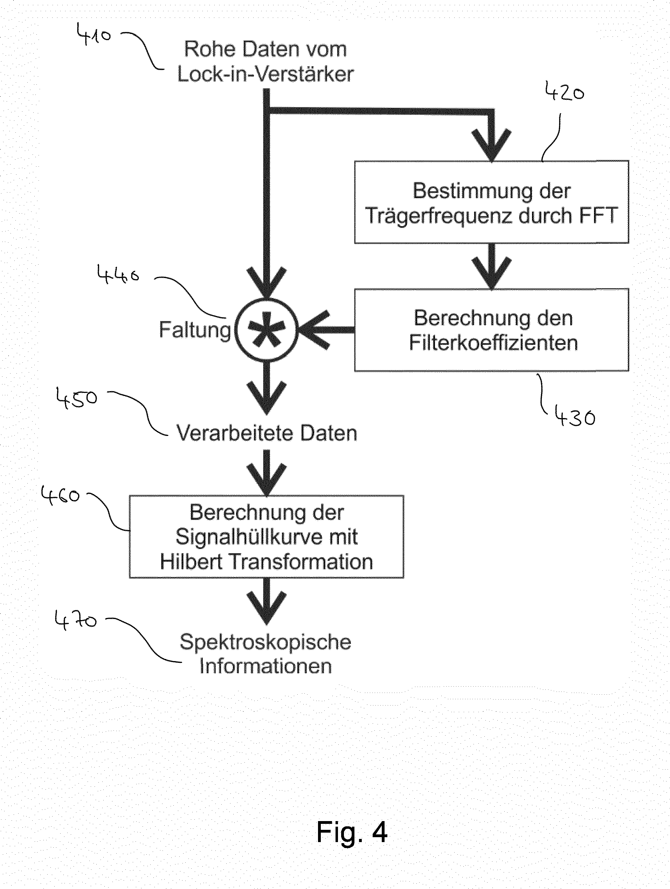

**Fig. 4** zeigt ein Flussdiagramm der Methode gemäß einem weiteren Ausführungsbeispiel. Wie bereits dargelegt können die Schritte S120, S130 und S140 (siehe Fig. 1) durch eine Faltung im Frequenzbereich umgesetzt werden.

In einem ersten Schritt 410 wird das gefilterte Frequenzsignal 115 (z.B. Rohdaten aus einem beispielhaften Lock-in-Verstärker) bereitgestellt. Dieser Schritt entspricht dem Schritt S110 aus der Fig. 1. Basierend auf dem Frequenzsignal 115 kann mittels einer schnellen Fourier-Transformation (FFT) im Schritt 420 eine Trägerfrequenz in dem Frequenzsignal 115 ermittelt werden. Im Schritt 430 werden die Filterkoeffizienten zu der bestimmten Trägerfrequenz bestimmt. Diese Filterkoeffizienten definieren das Zeitfenster im Zeitbereich (siehe Fig. 3(b)). Mit den ermittelten Filterkoeffizienten wird im Schritt 440 eine Faltung mit dem bereitgestellten Frequenzsignal 115 (im Schritt 410) durchgeführt. Die so erhaltenen Daten werden im Schritt 450 bereitgestellt. Im Schritt 460 wird eine Signalhüllkurve ermittelt (z.B. über eine Hilbert-Transformation). Das Ergebnis entspricht dem Signal aus der Fig. 3(c) und kann im Schritt 470 einer spektralen Verarbeitung (z.B. in dem Verarbeitungsmodul 130) zugeführt werden.

Wie bereits dargelegt, kann es bei dieser Vorgehensweise zu einer verringerten Frequenzauflösung kommen, was einen verfahrensbedingten Nachteil darstellen könnte. Allerdings verfügen Dauerstrich-Spektrometer - im Vergleich zu gepulsten Zeitbereichsspektrometern - über eine sehr hohe Frequenzauflösung (z.B. 1 MHz oder besser). Üblicherweise ist die Frequenzauflösung der Dauerstrich-Spektrometer um ca. 1.000 mal besser als Zeitbereichsspektrometer. Daher wäre bei den meisten Messungen eine Reduktion der Auflösung, z.B. um einen Faktor 10, kaum sichtbar. Die Verringerung der Auflösung kann zudem (näherungsweise) berechnet werden.

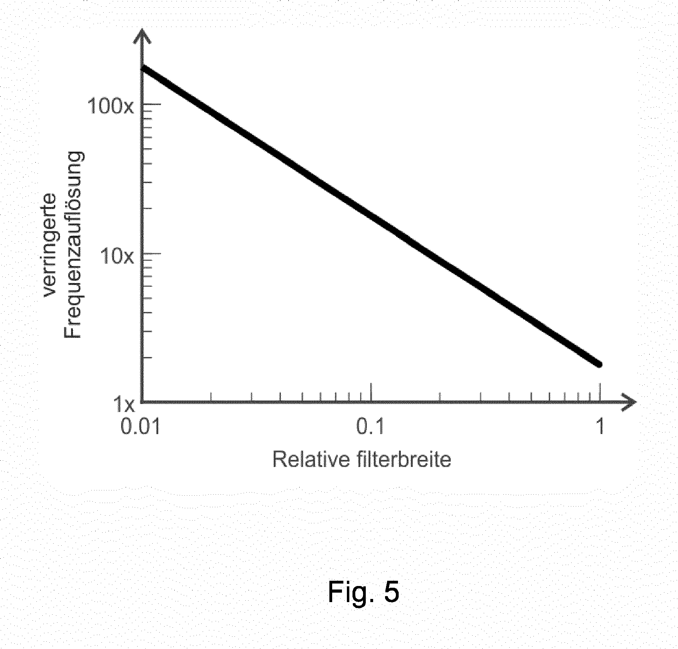

**Fig. 5** zeigt eine Darstellung, die den Zusammenhang der Verringerung der Frequenzauflösung in Abhängigkeit von der relativen Filterbreite (Filterbreite/Gesamtlänge) im Zeitbereich mit einem beispielhaften Rechteckfilter darstellt. Mit dieser Darstellung kann der Verlust der Frequenzauflösung abgeschätzt werden bzw. abgewogen werden mit der inhärent großen Frequenzauflösung der Dauerstrich-Spektrometern.

Gemäß Ausführungsbeispielen können als Bandpassfilter im Transformationsmodul 120 die folgenden (digitale) Filtertypen genutzt werden:
(1) Sogenannte IIR-Filter (infinite impulse response filter), die folgenden Eigenschaften aufweisen:
   - unendlicher Impulsantwort
   - effizienter als ein FIR-Filter (siehe unten)
   - nützlich auch für analoges Signal
   - nicht-linearer Phasengang
   - nicht immer stabil;
(2) Sogenannte FIR-Filter (finite impulse response filter), die folgenden Eigenschaften aufweisen:
   - endlicher Impulsantwort
   - linearer Phasengang
   - sind immer stabil
   - höhere Filterordnung als ein IIR-Filter

Üblicherweise haben die FIR- und IIR-Filter ein Flat-top Frequenzspektrum, woran eine 3-dB Bandbreite des Durchlassbereichs und die Dämpfung des Sperrbereichs durch Veränderung der Filterordnung kontrolliert werden können. Das Frequenzspektrum des Bandpassfilters könnte auch für verschiedene Fensterfunktionen (zur Definition des Bereiches 320 in Fig. 3(b)) definiert werden. Zur Auswahl der richtigen Fensterfunktion werden die folgenden Kriterien verwendet:
- Breite der Hauptmaximums (2): Breitere Filter um das Hauptmaximum stellen erhöhte Frequenzauflösung sicher aber der Dynamikbereich wird weniger stark verbessert,
- relative Dämpfung der Nebenmaxima: höhere Dämpfung lässt weiniger Außerbandrauschen durch; Filter mit einem rechteckigen Durchlassbereich (Filter mit gleitendem Mittelwert) dämpfen die Nebenmaxima ca. 13 dB; im Gegensatz kann ein Filter mit ein Kaiser-Bessel Fensterfunktion bis zu 82 dB dämpfen,
- Leck-Faktor, und
- Maximaler Abtastfehler

Ausführungsbeispiele nutzen als Fensterfunktionen: Bartlett, von Hann, Hamming, Kaiser-Bessel, Blackman usw. Diese und andere Fensterfunktionen sind einem Fachmann geläufig.

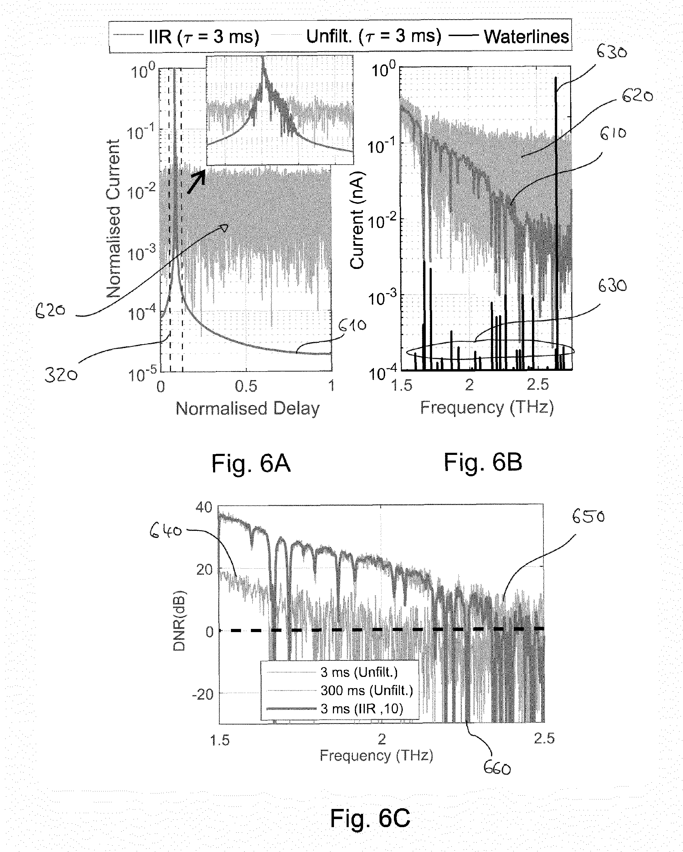

**Fign. 6A-6C** zeigen Vergleichsexperimente, die die Leistungsfähigkeit von Ausführungsbeispielen bei der Bandbreitenerweiterung anhand der Vermessung von Wasserdampfabsorptionslinien in Luft veranschaulichen.

**Fig. 6A** zeigt eine normierte Größe (Stromstärke im elektrisches Überlagerungssignal 24) des Zeitbereichsimpulses, der einem kontinuierlichen Frequenzscan zwischen 1,5 - 2,7 THz mit einer Integrationszeit von τ = 3 ms entspricht. Der Filter dämpft das Rauschen 620 außerhalb der Pulsdauer (Fenster 320) um ~ 60 dB. Der Inset zeigt die Größe des äquivalenten Pulses zwischen einer normalisierten Verzögerung von 0,075 - 0,115.

**Fig. 6B** zeigt einen Vergleich zwischen den Rohdaten 620 und den gefilterten Werten 610 des gemessenen Stroms am Detektor. Ohne die Filterung mit dem beispielhaften IIR Filter (Signal 620) wäre das Signal vollständig unsichtbar in dem Rauschen. Erst durch das Filtern wird das Rauschen so weit unterdrückt, dass das Signal 610 sichtbar wird. Mit dem Signal werden auch die Wasserabsorptionslinien 630 bei höheren Frequenzen sichtbar. Bei konventionellen System wären diese Absorptionen unsichtbar, während bei Ausführungsbeispielen die Wasserabsorptionslinien 630 bis zu ~ 2,4 THz sichtbar werden. Oberhalb von 2,6 THz wird die Signalleistung mit der Rauschuntergrenze vergleichbar. Daher können Wasserabsorptionsspektren nicht mehr genau von Rauschartefakten unterschieden werden.

**Fig. 6C** zeigt einen Vergleich im Dynamikbereich (DNR) zwischen ungefilterten Hüllkurvendaten mit τ = 3 ms (Signal 640), τ = 300 ms (Signal 650) und einer gefilterten Version (Signal 660) von den Daten 640 mit einem IIR-Filter der Ordnung 10. Der gefilterte Datensatz 660 hat eine ähnliche DNR wie die Daten 650, die jedoch eine lange Integrationszeit brauchen. Die Wasserabsorptionsspektren (Einbuchtungen in dem Signal 660) sind selbst bei Frequenzen über 2 THz deutlich erkennbar, wo ansonsten lange Integrationszeiten von 300 ms erforderlich wären.

Somit ermöglichen Ausführungsbeispiele die Nutzung von Intergrationszeiten im Lock-in-Verstärker von nur einigen Millisekunden (z.B. 1 ... 3 ms oder weniger als 5 ms oder weniger als 10 ms).

Wesentliche Aspekte von Ausführungsbeispiele können wie folgt zusammengefasst werden:
Das im Frequenzbereich gemessene, verrauschte, Empfangssignal (welches proportional zur THz Feldstärke ist) wird in den Zeitbereich transformiert. Das Messsignal erscheint dort als Peak. Zudem treten weitere Peaks auf, die durch reflektierende Elemente verursacht sein können. Dies inkludiert sowohl erwünschte Elemente, wie z.B. Vielfachreflexionen einer zu vermessenden Probe, als auch unerwünschte Elemente, wie Fabry-Perot Oszillationen in Optiken oder Stehwellen im System.

Ein schmaler Bandpass-Filter (Zeitfenster 320) wird um die gewünschten Elemente (z.B. Hauptmaximum) implementiert, was im Wesentlichen drei Konsequenzen hat:
1.) Rauschen außerhalb des Passbandes wird weggedämpft. Dies führt zu einer drastischen Reduktion des weißen Rauschens. Die Reduktion ist in etwa die Breite des Zeitbereichs dividiert durch die Breite des Filters.
2.) Unerwünschte Stehwellen im Aufbau werden herausgefiltert, das Signal wird sauberer.
3.) Die Auflösung des Systems mag sich verschlechtern.

Anschließend wird das gefilterte Signal wieder in den Frequenzbereich rücktransformiert, um das Leistungsspektrum aus dem Feld errechnen zu können.

Somit weisen Ausführungsbeispielen zumindest die folgenden Vorteile auf:
- Erhöhung der Bandbreite und/oder des Durchstimmbereichs von photonischen Dauerstrich THz Systemen wird erreicht.
- Erreichen eines gewünschten Signal-zu-Rausch Verhältnisses bzw. Dynamikbereichs mit deutlich kürzerer Messzeit als bei Standardtechniken.
- Es wird eine Synergie mit photonischen Dauerstrichsysteme erreicht, die auf elektro-optischen Quellen und Detektoren beruhen (nicht nur Photomischer und Photoleiter; weitere Beispiele wären optisch gepumpte Schottky-Dioden oder optisch getriebene resonante Tunneldioden), da dort die Verschlechterung der Auflösung kompensiert wird; außerdem hätte diese Technik bei elektronischen Systemen keinen Einfluss auf die Bandbreite, wo dann der Nachteil der geringeren Auflösung zum Tragen kommt.
- Eine Verbesserung der Signalqualität wird erreicht.
- Die Berechnung braucht nur eine sehr kurzen Rechenzeit, die sich auf einen Sekundenbruchteil beläuft, sodass die Technik auch auf Echtzeit-Messungen bzw. auf Messungen mit hohen Datenraten angewendet werden kann.

Die folgenden Nachteile von konventionellen Systemen werden überwunden:
- Scharfe spektroskopische Signaturen ("spektrale Fingerprints") sind bei der Nutzung der Wavelet-Techniken nachteilig, da diese Technik Einfluss auf die Peakform nimmt.
- Bei gepulsten Systemen hätte die Anwendung von Filtern im Zeitbereich wenig Einfluss auf die zur Verfügung stehende Bandbreite. Auch die Messzeit kann dort nicht verringert werden - im Gegensatz zu Ausführungsbeispielen.

Die in der Beschreibung, den Ansprüchen und den Figuren offenbarten Merkmale der Erfindung können sowohl einzeln als auch in beliebiger Kombination für die Verwirklichung der Erfindung wesentlich sein.

### BEZUGSZEICHENLISTE

- 20: Empfangssignals
- 24: elektrisches Überlagerungssignal
- 30: Laserquelle
- 90: Photomischer
- 110: Bereitstellungsmodul
- 115: Eingangssignal (z.B. gefilterten Frequenzsignals)
- 120: Transformationsmodul
- 125: Ausgabe-Frequenzsignal
- 130: Verarbeitungsmodul
- 135: Leistungsspektrums
- 310: Hochfrequentes Rauschen (herausgefiltert)
- 320: Durchlassbereich (Zeitfensters)
- 330: herausgefilterte/r Zeitbereich(e)
- 410...470: Schritte beim Filtern
- 610: gefilterte Werte/Signale
- 620: Rohdaten (ungefiltert)
- 630: Spektrallinien
- 640: ungefilterte Signal (kurze Integration)
- 650: ungefilterte Signal (lange Integration)
- 660: gefilterte Signal

## Patentansprüche

1. Verfahren zur Bandbreitenerweiterung eines photonischen Dauerstrich-Spektrometers für ein Empfangssignal (20) in einem Terahertz-Frequenzbereich, das Verfahren umfasst:
Bereitstellen (S110) eines Eingangssignals (115) im Frequenzbereich basierend auf dem Empfangssignal (20);
Transformieren (S120) des Eingangssignals (115) in ein Zeitsignal;
Ermitteln (S125) eines digitalen Filters;
Filtern (S130) des Zeitsignals oder des Eingangssignals (115) durch den ermittelten digitalen Filter, wobei ein Ausgabe-Frequenzsignal (125) erzeugt wird; und
Spektrale Verarbeitung (S150) des Ausgabe-Frequenzsignals (125) zur Ermittlung eines Leistungsspektrums (135).

2. Verfahren nach Anspruch 1, wobei der Schritt des Filterns (S130) wie folgt ausgeführt wird:
Rücktransformieren des digitalen Filters in den Frequenzbereich und Ausführen einer Faltung im Frequenzbereich; oder
durch eine Multiplikation mit einer Fensterfunktion im Zeitbereich gefolgt von einem Rücktransformieren (S140) des gefilterten Zeitsignals in ein Ausgabe-Frequenzsignal (125).

3. Verfahren nach Anspruch 1 oder Anspruch 2, wobei in dem Schritt des digitalen Filterns (S130) Folgendes verwendet wird:
ein Filter mit unendlicher Impulsantwort, IIR-Filter, oder
ein Filter mit endlicher Impulsantwort, FIR-Filter.

4. Verfahren nach Anspruch 2 oder Anspruch 3, wobei der Schritt des Filterns (S130) des Zeitsignals Folgendes umfasst:
Bestimmen eines Hauptmaximums;
Herausfiltern von Nebenmaxima durch Festlegen der Fensterfunktion, wobei die Fensterfunktion basierend auf das bestimmte Hauptmaximum festgelegt wird.

5. Verfahren nach einem der vorhergehenden Ansprüche, wobei in dem Schritt des Bereitstellens (S110) des gefilterten Frequenzsignals (115) zumindest eines aus dem Folgendes verwendet wird:
- ein homodyner Photomischer (90),
- ein heterodyner Photomischer (90),
- einen Lock-in Verstärker mit einer Integrationszeit in einem Bereich von 1 µs bis zu 1 s oder in einem engeren Bereich von 1 ms bis 300 ms oder von höchstens 5 ms,
- rauscharmer Transimpedanzverstärker;
- ein Frequenzfilter.

6. Verfahren nach einem der vorhergehenden Ansprüche, wobei die Bandbreite im Frequenzbereich zumindest 1 THz oder zumindest 5 THz ist.

7. Ein Computer-lesbares Speichermedium mit darauf gespeichertem Software-Code, der ausgebildet ist, um das Verfahren nach einem der Ansprüche 1 bis 6 auszuführen, wenn der Software-Code durch eine Verarbeitungseinheit ausgeführt wird.

8. Vorrichtung zur Bandbreitenerweiterung eines photonischen Dauerstrich-Spektrometers für ein Terahertz-Empfangssignal, die Vorrichtung umfasst Folgendes:
Bereitstellungsmodul (110) zur Bereitstellung eines Eingangssignals (115) im Frequenzbereich basierend auf dem Empfangssignals (20);
Transformationsmodul (120), das ausgebildet ist, um das Eingangssignal (115) im Zeitbereich zu transformieren und eine Filterfunktion digital zu ermitteln;
Verarbeitungsmodul (130), das ausgebildet ist, um
die Filterfunktion mit dem Eingangssignal (115) zu falten, um Ausgabe-Frequenzsignals (125) zu ermitteln;
ein Leistungsspektrum (135) des Ausgabe-Frequenzsignals (125) zu berechnen.

9. Vorrichtung nach Anspruch 8, wobei das Bereitstellungsmodul (100) einen rauscharmen Transimpedanzverstärker und/oder einen Frequenzfilter und/oder einen Lock-in-Verstärker aufweist.

10. Vorrichtung nach Anspruch 8 oder Anspruch 9, wobei das Transformationsmodul (120) ausgebildet ist, um Folgendes auszuführen:
- Filtern im Zeitbereich über ein Falten im Frequenzbereich, oder
- Transformieren in den Zeitbereich, Anwenden einer Fensterfunktion, Rücktransformieren in den Frequenzbereich.
